Europäisches Patentamt

European Patent Office

Office européen des brevets

(11) Publication number: **0 227 076 B1**

# EUROPEAN PATENT SPECIFICATION

(45) Date of publication of patent specification: **17.06.92**  (51) Int. Cl.5: **H01L 21/268, C30B 1/06**

(21) Application number: **86117799.6**

(22) Date of filing: **19.12.86**

(54) Method of manufacturing monocrystal thin-film.

(30) Priority: **20.12.85 JP 285438/85**
**28.03.86 JP 68554/86**
**26.09.86 JP 225900/86**

(43) Date of publication of application:
**01.07.87 Bulletin  87/27**

(45) Publication of the grant of the patent:
**17.06.92 Bulletin  92/25**

(84) Designated Contracting States:
**DE FR GB**

(56) References cited:
**FR-A- 2 537 607**

**APPLIED PHYSICS LETTERS vol. 38, no. 4, February 1981, pages 248-250, New York, US; T.L. MAGEE et al.: "Seeded and limited seeding regrowth of Si over Si02 by cw laser annealing"**

**JAPANESE JOURNAL OF APPLIED PHYSICS. SUPPLEMENTS vol. 21, supplement 1, 1982, pages 193-198, Tokyo, JP; M. TAMURA et al.: "Laser-Induced Lateral, Vertically-Seeded Epitaxial Regrowth of Deposited Si Films over Various Si02 Patterns"**

(73) Proprietor: **AGENCY OF INDUSTRIAL SCIENCE AND TECHNOLOGY**
**3-1, 1-chome, Kasumigaseki**
**Chiyoda-ku Tokyo(JP)**

(72) Inventor: **Awane, Katunobu**
**15-2, Shinasahigaoka**
**Ikoma-shi Nara-ken(JP)**
Inventor: **Koba, Masayoshi**
**51-14-5, Shichijonishimachi 1-chome**
**Nara-shi Nara-ken(JP)**
Inventor: **Miyajima, Toshiaki**
**6-13-13, Tatsutanishi Ikaruga-cho**
**Ikoma-gun Nara-Ken(JP)**
Inventor: **Maekawa, Masashi**
**1-1-602, Kunimi-cho Saidaiji**
**Nara-shi Nara-ken(JP)**

(74) Representative: **von Kreisler, Alek, Dipl.-Chem. et al**
**Deichmannhaus am Hauptbahnhof**
**W-5000 Köln 1(DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

JOURNAL OF THE ELECTROCHEMICAL SOCI-
ETY vol. 132, no. 8, August 1985, pages
1919-1924, Manchester, New Hampshire, US;
J.R. Davies et al.: Characterization of the
Dual E-Beam Technique for Recrystallizing
Polysilicon Film"

JAPANESE JOURNAL OF APPLIED PHYSICS;
SUPPLEMENTS 18th International Confer-
ence on Solid State Devices and Materials,
Tokyo, JP, 20th-22nd August 1986, pages
565-568, Tokyo, JP; K. SUGAHARA:
"Orientation Control of SOI Film by Laser
Recrystallization"

## Description

The present invention relates to a method of manufacturing a monocrystal thin-film to be used in a field where a semiconductor device is manufactured, and more particularly, to improvements in a method of performing the monocrystallizing operation, i.e., single crystallizing operation through the application of energy beams upon the non-monocrystal thin-film of non-crystalloid, i.e., amorphous or ., polycrystals formed on the non-crystalloid insulation film.

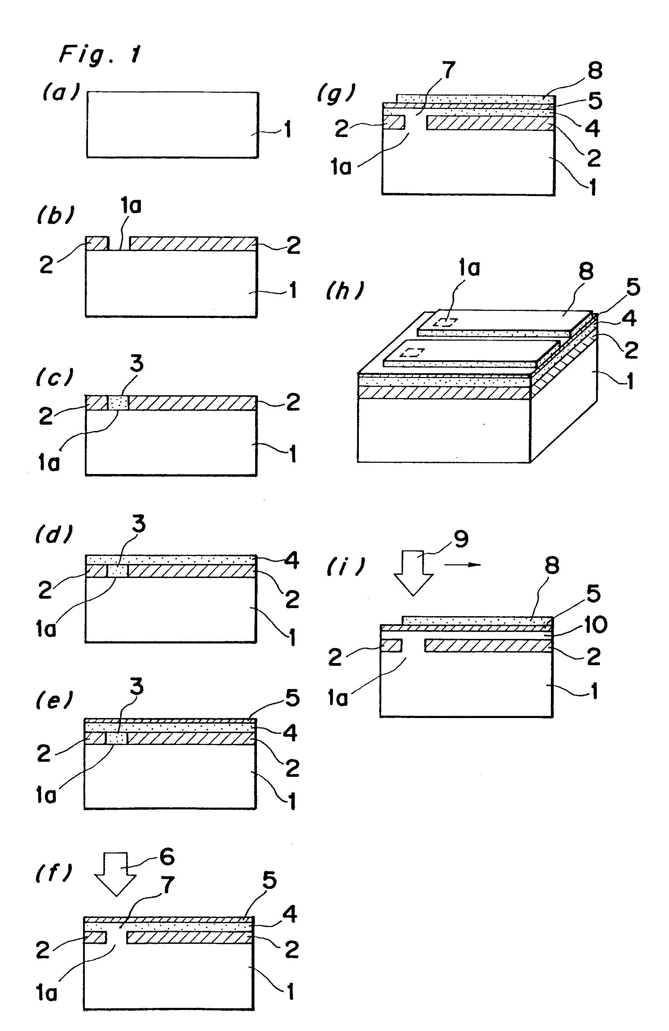

Journal of the Electrochemical Society 132, 8. August 1985, page 119-129 discloses a method of silicon thin film single crystal production on oxidized {100} = (001) silicon wafers supplied with an opening portion, or seeding windows, and a polysilicon film deposited on the surface, including the opening portion. The use of energy beams on the non-monocrystal silicon film is indicated in Fig. 1 and the growth of single crystal by application of the beam in the <100> direction is also in Fig. 1 and the text on page 1920, first paragraph.

Conventionally, a method of manufacturing a monocrystal thin film with monocrystal silicon base plate coinciding in the crystal direction therewith is proposed through forming a non-crystalloid or multicrystal thin film on an insulating film formed on the monocrystal silicon base-plate, i.e., substrate, and through performing molten-recrystallizing operation by the application of energy beams on the thin film.

According to the conventional method, when the insulating film is increased in thickness between the monocrystal silicon base-plate and the non-crystalloid or multicrystal thin film to be monocrystallized, the monocrystalloid or multicrystal thin film near the insulating film flows into the insulating film when it is melted through the application of the energy beams to make the non-crystalloid or multicrystal thin-film thinner near the insulating film. Thus, the crystal growth is not continuously caused from the non-crystalloid or multicrystal thin film in the region which is in contact against the monocrystal silicon base-plate into the non-crystalloid or multicrystal thin film on the insulating film.

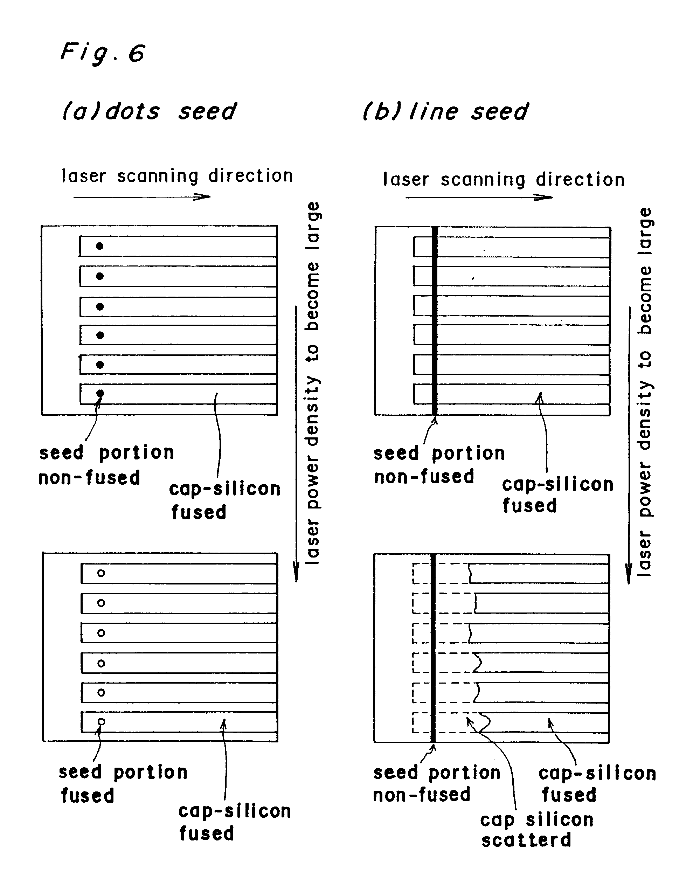

Also, when the insulating film increases in thickness with the monocrystal silicon base-plate being stripe-shaped in form, the monocrystal silicon base-plate and the base plate on the insulating plate are largely different in thermal conduction. The considerable temperature difference is caused in the non-crystalloid or multicrystal thin-film during the application of the energy beams so that the superior monocrystal thin film is not provided. Fig. 6 shows a case where the form of the monocrystal silicon base-plate is stripe-shaped or dot-shaped in a known manner. It is found out that the superior molten condition is not provided in the case of the stripe-shape.

Accordingly, an object of the present invention is to provide a method of manufacturing a monocrystal thin film of silicon, which forms the monocrystal thin film controlled in crystal direction, superior in quality through the application of the energy beams.

For the solution of the conventional problems, the method of manufacturing a monocrystal thin-film of the present invention comprised the successive steps of claim 1. Further embodiments can be found in the dependent claims 2 to 4. The region, where the monocrystal silicon base-plate covered with the non-crystalloid insulating film is exposed, rectangular or almost circular in dot-shape, followed by scanning the energy beams onto the region from the monocrystal silicon base-plate exposed portion of the non-crystalloid or multi-crystal thin-film continuously formed on the mono-crystalloid silicon base-plate exposed portion and the insulating film to provide the monocrystal thin-film coinciding with the monocrystal silicon base-plate in the crystal direction.

Also, it is preferable that the size of the insulating film opening-portion is 4 $\mu$m square (or 4 $\mu$m in diameter) or less and the insulating film opening-portion should be filled in advance with the same material as the material to be mono-crystallized.

When the energy beams are applied upon the monocrystalloid or multicrystal thin-film on the insulating film and upon the non-crystalloid or multicrystal thin-film on the non-crystalloid or multicrystal thin-film buried in the monocrystal silicon base-plate exposed portion, the temperature is likely to rise in the non-crystalloid or multicrystal thin-film on the insulating film if the thermal conductivity of the film is smaller than the thermal conductivity of the non-crystalloid or multicrystal thin film in the monocrystal silicon base-plate exposed portion. When the exposed portion of the monocrystal silicon base-plate is stripe-shaped or becomes more than 4 $\mu$m square, the amount of the heat that escapes to the base plate through the non-crystalloid or multicrystal thin-film within the insulating-film opening portion therein becomes large so that the non-crystalloid or multicrystal thin-film on the opening portion becomes hard to melt. When the power density of the energy beams is raised till the non-crystalloid or multicrystal thin film within the opening portion is melted, scattering is caused in the non-crystalloid or multicrystal thin-film on the insulating film. Such a problem as described hereinabove become more considerable when the insulating film to be formed on the monocrystal silicon base-plate becomes thicker. In the three-dimension circuit element with elements such as transistors or the like being layer-built into many layers, the insulating film thickness between the respective achieve layers becomes as thick as 2 through 4 $\mu$m or more.

In the present invention, the configuration of the insulating-film opening portion is made square or almost circular in dot shape and the size thereof is made 4 $\mu$m or lower, so that the amount of heat escaping into the base plate through the opening portion becomes smaller, the difference between the temperature of the non-crystalloid or multicrystal thin-film on the opening portion and the temperature of the non-crystalloid or multicrystal thin-film on the insulating film becomes smaller through the thermal conduction from the periphery to simultaneously melt both portions of the above non-crystalloids or multicrystal thin-films without scattering.

Also, the insulating-film opening portion is filled in advance with a piece of the non-crystalloid or multicrystal thin film. The molten thin-film flows into the insulating film opening portion from the periphery of the opening portion during the application of the energy beams to prevent the non-crystalloid or multicrystal thin-film from becoming thinner so that the crystal growth of the monocrystal thin-film is caused continuously onto the insulating film from on the insulating film opening portion.

Accordingly, the monocrystals may grow from the monocrystal silicon base-plate exposed portion stably if the insulating film increases in thickness through the above-described operation.

## BRIEF DESCRIPTION OF THE DRAWINGS

These and other objects and features of the present invention will become apparent from the following description taken in conjunction with the preferred embodiment thereof with reference to the accompanying drawings, in which:

Figs. 1(a) through 1(i) are respectively process charts showing sample sections for illustrating a method of manufacturing monocrystal thin-film in accordance with one embodiment of the present invention;

Fig. 2 is a view for illustrating the forming direction, i.e., crystal growth direction, of the stripe-shaped thin film on the application of the method of the present invention;

Figs. 3(a) and 3(b) show a principle chart for illustrating a method of controlling the reflection factor to provide the given temperature distribution to be employed in the method of the present invention;

Fig. 4 is a chart showing the influences of the size of the insulating-film opening portion applies upon the seeding factor in the method of the present invention;

Fig. 5 is a chart showing the relationship between the laser scanning direction and the length of the monocrystal wherein the monocrystal region is enlarged from the seed portion to be employed in the method of the present invention; and

Figs. 6(a) and 6(b) show views for illustrating the molten condition between the dot shape and the stripe shape in the form of the insulating-film on the employment of a conventional method.

## DETAILED DESCRIPTION OF THE INVENTION

Referring now to the drawings, there are shown process charts for illustrating one embodiment of the present invention in Figs. 1 (a) through 1(i).

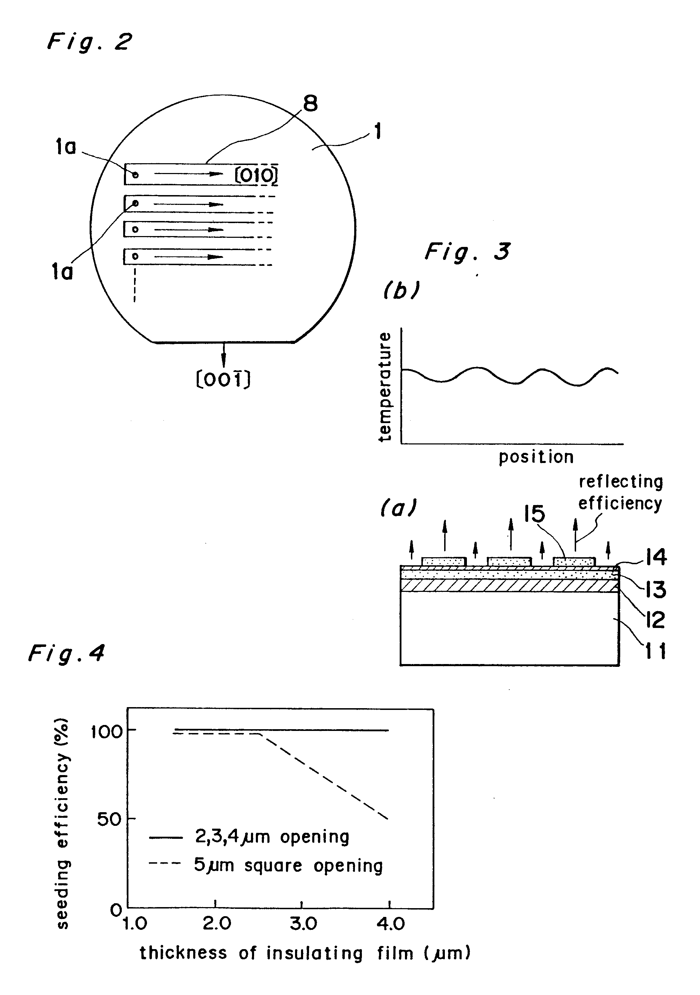

First, an insulating film 2 of non-crystal is formed on a top plane of a (100) monocrystal silicon base-plate 1 being partially exposed to provide an exposed portion 1a, as shown in Fig. 1(b), of the monocrystal silicon base-plate 1, as shown in Fig. 1(a). At this time, the size of the monocrystal silicon base-plate exposed portion is assumed to be 3 $\mu$m square. Firstly, the $SiO_2$ film of 2 $\mu$m in thickness is formed on the monocrystal silicon base-plate 1 by means of, for example, a known thermal oxidation method. Thereafter, the monocrystal silicon base-plate 1 of the $SiO_2$ film is selectively by a known photoeching method only in the portion to be exposed to form a plurality of opening portions 1a, 1a, 1a, ... of dot shapes, each being 3 $\mu$m square with an interval of 15 $\mu$m, as shown in Fig. 2.

Then, a piece of non-crystalloid or multicrystal silicon thin film 3 which is almost equal in thickness to the insulating film 2, as shown in Fig. 1(c), is embedded only into the exposed portion 1a of the monocrystal silicon base-plate 1 provided in and surrounded by the insulating film 2. Concretely, the non-crystalloid silicon thin-film or multicrystal silicon thin-film is formed by a known LPCVD method on the whole surface of the insulating film 2 including the opening portion 1a therein. Then, organic application film material is applied evenly on the whole surface of the non-crystalloid or multicrystal silicon thin-film, which is formed unevenly on the surface corresponding to the opening portion 1a of the monocrystal silicon base-plate 1 and the surface of the insulating film 2, to form an organic application film. Thereafter, equal-speed etching is performed from the surface of the organic application film surface to transfer the even surface of the initial organic application film, and the etching operation is stopped in a time point when the insulating film 2 has been exposed filling the non-crystalloid or multicrystal silicon thin-film 3 into the opening portion 1a of the insulating film 2, as shown in Fig. 1(c).

It is to be noted that, upon the completion of the etching, the step difference in surface between the non-crystalloid or multicrystal silicon thin film 3 filled in at this time, and the insulating film 2 is assumed to be 1 $\mu$m or less.

Then, a non-crystalloid or multicrystal silicon thin film 4 which becomes an active layer of 0.6 $\mu$m in thickness is formed by the LPCVD method on both regions by the upper portion of the thin film 3 filled in and of the upper portion of the insulating film 2, as shown in Fig. 1(d). Then, an SiO$_2$ film which serves as a surface protective film, i.e., anti-reflective film 5 for the silicon thin film 4 is formed by the APCVD method 850 Å in thickness on the whole surface of the silicon thin film 4, as shown in Fig. 1(e).

Next, a bundle of laser beams 6 of 60 $\mu$m in molten width and 10W in power is applied upon the region including the monocrystal silicon base-plate exposed portion 1a, as shown in Fig. 1(f), and the mono-crystalloid or multicrystal thin-film 4 on the monocrystal silicon base-plate exposed portion 1a is caused to mono-crystallize with the monocrystal silicon base-plate exposed portion 1a which is adapted as a seed for mono-crystal, so that the monocrystal thin-film 7 is obtained in the crystal direction in coincidence with that of the monocrystal silicon base-plate 1.

Then, a non-crystalloid or multicrystal silicon thin-film 8 of stripe-shape on the surface of the surface protective film 5, as shown in Figs. 1(g) and 1(h) such that the longitudinal direction of the stripe may become ⟨010⟩ of the monocrystal silicon base plate 1, as shown in Fig. 2. Concretely, the non-crystalloid or multicrystal silicon thin film 8 is formed 0.6 $\mu$m in thickness by the LPCVD method on the surface protective film 5, and is made stripe-shaped through the selective etching operation by a known photo-etching method. At this time, each stripe of the non-crystalloid or multicrystal silicon thin film 8 is formed to cover the monocrystal silicon base-plate exposed portion 1a with the width of stripe being 10 $\mu$m, the internal between the stripes being 5 $\mu$m.

Finally, the scanning operation of the laser beam 9 of 60 $\mu$m in molten width and 12 W in power is effected from the monocrystal silicon base-plate exposed portion 1a with the scanning speed of 100 mm per second in the longitudinal direction of the stripe-shaped non-crystalloid or multicrystal silicon thin-film 8, as shown in Fig. 1(i), to provide a monocrystal silicon thin film 10 in which the non-crystalloid or multicrystal silicon thin-film 4 is mono-crystallized with the filled silicon 7 coincided with the monocrystal silicon base-plate 1 in the crystal direction being provided as the seed. With the above process, the monocrystal silicon (100) thin-film 10 coincided (100) with the monocrystal silicon (100) base-plate 1 in the crystal direction is finally obtained on the surface of the insulating film 2. It is to be noted that the reason why the stripe-shaped non-crystalloid or multi-crystal silicon thin-film 8 is formed is that the reflection factor, i.e., reflectivity of the laser beam 9 in the place where the stripe-shaped silicon is located is enlarged compared to that where the stripe-shaped silicon does not exist, as shown in Fig. 3(a), the solidification for monocrystallization starts from right under the stripe-shaped silicon central portion with such temperature distribution being provided, as shown in Fig. 3(b), and the monocrystal growth of the silicon thin film 10 is caused with the monocrystal silicon base-plate exposed portion 1a as the seed.

How the seeding factor of the seed is changed by the insulating film 2 thickness when the size of the insulating film opening portion 1a is changed is examined for comparison, with a result as shown in Fig. 4. When the opening of the opening portion 1a is as large as 5 $\mu$m square, the seeding factor is lowered if the insulating film 2 becomes as thick as 4 $\mu$m. Also, when it is 2 $\mu$m, 3 $\mu$m or 4 $\mu$m square, the seeding factor is not seen if the thickness of the insulating 2 film is made 4 $\mu$m. In the three-dimensional circuit element, the opening portion 1a will do well if it is made 4 $\mu$m square or less in size, because the thickness between the respective active layers is about 4 $\mu$m even at the largest.

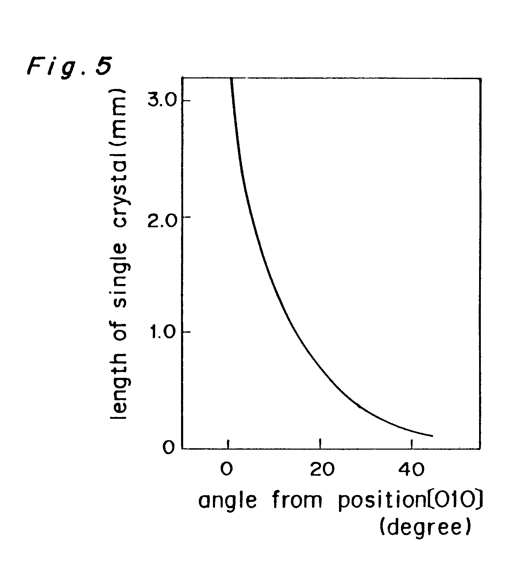

Also, it is to be noted that the reason why the crystal face of the (100) is used as the monocrystal silicon base-plate 1, and the laser scanning direction is made along the ⟨010⟩ is that the crystal defect is hardest to have in the combination of (100) and (010), and the monocrystal region may be smoothly enlarged from the seed portion. The length for which the monocrystal region extends from the seed portion when the laser scanning direction is varied between ⟨010⟩ and ⟨011⟩ by the use of the (100) monocrystal silicon base plate 1 is used as shown in Fig. 5. It is the most desirable from Fig. 5 that the laser scanning in the ⟨010⟩ direction is best.

As is clear from the foregoing description, according to the present invention, the superior monocrystal silicon thin-film 10 coincided with the monocrystal silicon base plate in the crystal direction is formed on the insulating film 2 even if the insulating film as thick as 4 $\mu$m is sufficiently covered between the active layers of the three-dimensional circuit element on the monocrystal silicon base plate 1.

## Claims

1. A method of manufacturing a monocrystal thin-film of silicon comprising the successive steps of forming a non-crystalline insulating film on a mono-crystal silicon base-plate, providing a dot shaped opening in the insulating film so that the corresponding portion of the monocrystal silicon base plate is exposed,

filling the dot-shaped opening of the insulating-film with a non-monocrystalline silicon thin-film,

forming a non-monocrystalline thin-film of silicon on said non-crystalline insulating film,

forming an anti-reflective film on said non-monocrystal thin-film,

applying energy beams upon the region including the dot shaped opening filled with the said non-monocrystalline silicon thin film to turn it into a monocrystal thin-film coinciding with the monocrystal silicon base-plate in crystal direction with the exposed portion of said monocrystal silicon base-plate provided as the seed,

forming a stripe-shaped silicon reflection enhancing film on said anti reflective film so that said monocrystallized region is included, and

applying energy beams in the stripe direction to monocrystallize said non-monocrystalline silicon thin-film formed on the insulating film with the monocrystallized film in the dot shaped opening being provided as the seed.

2. A method in accordance with claim 1, wherein the size of the dot-shaped opening is 4 $\mu$m or lower.

3. A method in accordance with claim 2, wherein the monocrystal silicon base-plate exposed portion which become the seed portion is multiply formed and a plurality of stripe-shaped silicon covered films are formed in accordance with said plurality of seed portions.

4. A method in accordance with claims 1 to 3, wherein the orientation of the monocrystal silicon base-plate is {100}, and the direction of the stripe-shaped silicon covered film is <100>.

## Revendications

1. Procédé de fabrication d'un film mince de silicium, monocristal, comprenant les étapes successives consistant à :
   - former un film isolant, non-cristallin, sur une plaque de base de silicium, monocristal ;
   - pratiquer une ouverture en forme de point dans le film isolant, de telle sorte que la partie correspondante de la plaque de base de silicium, monocristal, soit exposée ;
   - remplir l'ouverture en forme de point du film isolant par un film mince de silicium, non-monocristallin ;
   - former un film mince de silicium, non-monocristallin, sur ledit film isolant non-cristallin ;
   - former un film antiréflexion sur ledit film mince non-monocristal ;
   - appliquer des faisceaux énergétiques sur la région comprenant l'ouverture en forme de point remplie par ledit film mince de silicium, non-monocristallin, pour le transformer en un film mince monocristal coïncidant avec la plaque de base de silicium, monocristal, dans la direction du cristal, avec la partie exposée de ladite plaque de base de silicium, monocristal, ménagée en tant que germe cristallin ;
   - former un film de silicium, augmentant la réflexion, en forme de bande, sur ledit film antiréflexion, de telle sorte que ladite région rendue monocristalline soit incluse ; et
   - appliquer des faisceaux énergétiques dans la direction de la bande pour rendre monocristallin ledit film mince de silicium, non-monocristallin, formé sur le film isolant, avec le film rendu monocristallin dans l'ouverture en forme de point, ménagé en tant que germe cristallin.

2. Procédé selon la revendication 1, dans lequel la dimension de l'ouverture en forme de point est de 4 $\mu$m ou d'une valeur inférieure.

3. Procédé selon la revendication 2, dans lequel la partie exposée de la plaque de base de silicium, monocristal, qui devient la partie formant germe, est formée de façon multiple, et plusieurs films revêtus de silicium en forme de bandes, sont formés en conformité avec les différentes parties formant germe précitées.

4. Procédé selon l'une des revendications 1 à 3, dans lequel l'orientation de la plaque de base de silicium, monocristal, est {100}, et la direction du film revêtu de silicium en forme de bande, est <100>.

## Patentansprüche

1. Verfahren zur Herstellung eines Einkristall-Dünnfilms aus Silicium, umfassend die sukzessiven Schritte des Bildens eines nicht-kristallinen Isolierfilms auf einer Grundplatte aus einem Silicium-Einkristall,

des Herstellens einer punktförmigen Öffnung in dem Isolierfilm, so daß der entsprechende Teil der Grundplatte aus dem Silicium-Einkristall freigelegt wird, des Füllens der punktförmigen Öffnung des Isolierfilms mit einem nicht-einkristallinen Silicium-Dünnfilm, des Bildens eines nicht-einkristallinen Dünnfilms aus Silicium auf dem nicht-kristallinen Isolierfilm, des Bildens einer reflexmindernden Schicht auf dem nicht-einkristallinen Dünnfilm, des Einwirkenlassens von Energie-Strahlen auf den Bereich, der die mit dem nicht-einkristallinen Silicium-Dünnfilm gefüllte Öffnung einschließt, um ihn in einen einkristallinen Silicium-Dünnfilm umzuwandeln, der in seiner Kristallrichtung mit dem Silicium-Einkristall der Grundplatte zusammenfällt, wobei der freigelegte Teil der Grundplatte aus dem Silicium-Einkristall als Impfkristall dient, des Bildens eines streifenförmigen reflexionsverstärkenden Silicium-Films auf der reflexmindernden Schicht, so daß der einkristallisierte Bereich eingeschlossen wird, und des Einwirkenlassens von Energie-Strahlen in Richtung der Streifen, um den auf dem Isolierfilm gebildeten, nicht-einkristallinen Dünnfilm aus Silicium zu einkristallisieren, wobei der einkristallisierte Film in der punktförmigen Öffnung als Impfkristall dient.

2. Verfahren nach Anspruch 1, worin die Größe der punktförmigen Öffnung 4 $\mu$m oder weniger beträgt.

3. Verfahren nach Anspruch 2, worin der freigelegte Teil der Grundplatte aus dem Silicium-Einkristall, der zum Impfkristall-Teil wird, mehrfach gebildet wird und die streifenförmigen, mit Silicium bedeckten Filme gemäß der Mehrzahl der Impfkristall-Teile gebildet werden.

4. Verfahren nach den Ansprüchen 1 bis 3, worin die Orientierung der Silicium-Einkristall-Grundplatte {100} ist und die Richtung des streifenförmigen, mit Silicium bedeckten Films <100> ist.

Fig. 1

(a)

(b)

(c)

(d)

(e)

(f)

(g)

(h)

(i)

Fig. 2

Fig. 3

(b)

(a)

Fig.4

Fig. 5

## Fig. 6

### (a) dots seed

laser scanning direction

laser power density to become large

seed portion
non-fused

cap-silicon
fused

seed portion
fused

cap-silicon
fused

### (b) line seed

laser scanning direction

laser power density to become large

seed portion
non-fused

cap-silicon
fused

seed portion
non-fused

cap silicon
scatterd

cap-silicon
fused